Europäisches Patentamt

European Patent Office

Office européen des brevets

(19)

(11) EP 1 246 267 A1

(12) **EUROPEAN PATENT APPLICATION**

(43) Date of publication:
02.10.2002 Bulletin 2002/40

(51) Int Cl.$^7$: **H01L 41/047**

(21) Application number: 01870068.2

(22) Date of filing: 28.03.2001

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **Micromega Dynamics S.A.**
**4031 Angleur (BE)**

(72) Inventor: **Preumont, André**
**1450 Chastre (BE)**

(74) Representative: **Van Malderen, Michel et al**
**Office van Malderen**
**85/043 Boulevard de la Sauvenière**
**4000 Liège (BE)**

(54) **Method for shaping laminar piezoelectric actuators and sensors and related device**

(57) The present invention is related to a method for manufacturing a laminar piezoelectric, piezostrictive respectively, transducer, either a sensor or an actuator, with in-plane variable apparent piezoelectric, piezostrictive respectively, coefficients ($e_{31}$, $e_{32}$), comprising a piezoelectric, piezostrictive respectively, sheet covered on at least one of its faces by an electrode made of a conductive layer, characterised in that said in-plane coefficients ($e_{31}$, $e_{32}$) variation is obtained through the patterning of the electrode, by providing said conductive layer with a plurality of internal non-conductive zones.

FIG.6

EP 1 246 267 A1

## Description

### Field of the invention

The present invention is related to a method for tailoring in two dimensions the effective piezoelectric characteristics of laminar piezoelectric films.
The invention also concerns an electrode for the implementation of the method.

### Technological background and state of the art

Piezoelectric sensors and actuators are key components in vibration monitoring, active vibration control and active structural acoustic control.
The concept of modal filter is known and was first introduced for beam structures (S.E. BURKE and J.E. HUBBARD, IEEE Control Systems Magazine, Aug., 25-30, 1987). The filter consists of a continuous polyvinylidene fluoride (PVDF) strip bonded on the beam with an electrode shaped in such a way that the sensor is sensitive only to a single mode of vibration. The same shape can be used for a modal actuator and a modal sensor.
Potential applications of this modal filter include robust active damping of vibration and spillover alleviation.
The extension of these "selective modal transducers" to composite plates and shells has also been described (S.E. MILLER, Y. OSHMAN and H. ABRAMOVICH, AIAA Journal, Vol.34, No 9, 1868-1875, Sept. 1996 ; ibid. 1876-1884 ; S.E. MILLER, H. ABRAMOVICH and Y. OSHMAN, AIAA Journal, Vol.35, No 10, 1621-1629, Oct. 1997). The concept relies on the use of several layers, at least three, of piezoelectric material being embedded in the laminate. The sensing of selected modes is performed through combining the effect of three piezoelectric layers whose piezoelectric properties are varied spatially. The study does not give however any clue as to the way the piezoelectric properties can be varied spatially (assuming it can be done). Again, the selective modal actuator is based on the same principle.
Active structural acoustic control aims at controlling the noise radiated by vibrating structures through selective attenuation of the most efficient radiating modes. Feedback control requires a noise radiation sensor. At low frequency, a volume velocity sensor may be regarded as a close approximation of a noise radiation sensor.
Several concepts of volume velocity sensors based on piezoelectric films have been proposed. The QWSIS -Quadratically Weighted Strain Integrating Sensor- (J. REX and S.J. ELLIOTT, MOVIC-1, Yokohama, 339-343, Sept. 1992) consists of an array of narrow unidirectional PVDF strips with electrodes of parabolic shapes which measure the volume velocity of the elementary strips, considered as beams. Another method for measuring the volume velocity consists in placing two PVDF strips orthogonal to each other across a plate (F. CHARETTE, A. BERRY and C.GUIGOU, J.A.S.A., Vol.103, No 3, 1493-1503, 1997).
Alternatively, selective modal transducers can be constructed with array sensors (A. PREUMONT, A. FRANCOIS and S. DUBRU, ASME Journal of Vibration and Acoustics, Vol.121, 446-452, Oct. 1999 ; A. FRANCOIS, P. DE MAN and A. PREUMONT, accepted for publication in the ASME Journal of Sound and Vibration). Piezoelectric patches, disposed in an array, are bonded on the vibrating surface in a regular mesh and are connected to separate conditioning electronics and to a linear combiner. The coefficients or weights of the linear combiner are selected in such a way that the output of the array is proportional to any useful quantity which is linearly related to the modal amplitude, including single mode filters and volume velocity sensor.
However, as this method relies on discrete sensors, it is prone to spatial aliasing. The spatial aliasing can be alleviated by using a very fine mesh of sensors, but the increase in number of independent sensors renders the electronics much more complicated, which rapidly becomes prohibitive.
All the above techniques can theoretically be substituted by a suitable shaping of the piezoelectric properties of the material, which is difficult to achieve.
In WO-A-00 54 897 is described one sensor array configured as a linear strip with a frame segment having at least one longitudinally extending rail and a plurality of sensor elements extending therefrom. These sensor elements have a resilient core and opposing PVDF outer layers configured with opposing polarities onto the core.
Document FR-A-2 641 612 proposes a sensor comprising two plates of a piezoelectric material with opposite polarization axes, which bear on an inertial mass made of non-conductive material placed between them.
American patents No. US-A-5 982 708 and US-A-6 108 274 disclose each an acoustic sensor having one or more segments electrically coupled to provide a response to an acoustic pressure applied to the segments. Each segment contains at least one substrate of a desired shape and at least one or two active members made from a flexible, resilient piezoelectric material.
Patent No. US-A-6 046 961 describes a sonar sensor array having a multi-layer tiled arrangement for the individual elements that increases surface area available for each element while maintaining the inter-element spacing required to avoid spatial aliasing when the received signals are combined to form a sonar beam.
Patent No. US-A-4 472 653 discloses a surface acoustic wave device comprising on a piezoelectric substrate a first interdigital electrode array for converting electric signals into surface acoustic waves and a second interdigital electrode array for receiving the surface acoustic waves propagating from the first interdigital electrode array along the surface portion of the piezoelectric substrate to convert them into electric signals again.

In US-A-5 911 158, one proposes a single sheet of a piezoelectric polymer film coated on one side with a thin layer of conductive material to serve as a ground electrode, the other side of the sheet beeing coated with a thin layer or conductive material in a non-contiguous pattern of individual electrodes defining an array of discrete piezoelectric transducers. Sensor leads are connected to each individual electrode and lead to a signal processor which includes associated software.

Document EP-A-1 026 823 discloses a shear horizontal type surface acoustic wave device including a piezoelectric substrate, an electrode pattern with at least one interdigital transducer located on the substrate and a resinous film located on an entire area of the surface of the substrate, except for a portion of a lead electrode of the electrode pattern.

### Aims of the invention

The present invention aims to provide a solution which alleviates the drawbacks of prior art.

In particular, in the case of the electrodes included in piezoelectric array sensors, the invention aims at reducing and thus greatly simplifying the measurement electronics as well as the related connections.

The invention also aims at developing piezoelectric sensors as well as actuators with special spatial filtering properties.

One particular goal of the invention is to provide a modulation of the effective piezoelectric expansion coefficient of a piezoelectric film.

### Summary of the invention

The present invention is related to a method for manufacturing a laminar piezoelectric, piezostrictive respectively, transducer, either a sensor or an actuator, with in-plane variable apparent piezoelectric, piezostrictive respectively, coefficients, comprising a piezoelectric, piezostrictive respectively, sheet covered on at least one of its faces by an electrode made of a conductive layer, characterised in that said in-plane coefficients variation is obtained through the patterning of the electrode, by providing said conductive layer with a plurality of internal non-conductive zones or motifs.

Actually, the present invention should find application for any material showing electro-mechanical coupling. Thus, piezoelectric and piezostrictive materials are examples of significance for this more general behaviour. A piezoelectric, piezostrictive respectively, material is a material where the output voltage, the square output voltage respectively, is proportional to the applied strain, and inversely.

It is another object of the present invention to provide a patterned electrode for a laminar piezoelectric or piezostrictive transducer, consisting in a sheet of electrically conductive material.

It is still another object of the present invention to provide a piezoelectric transducer comprising a laminar piezoelectric material intercalated between two laminar mechanical structures, on which is laid at least such a patterned electrode.

It is still another object of the present invention to provide a piezostrictive transducer comprising a laminar piezostrictive material intercalated between two laminar mechanical structures, on which is laid at least such a patterned electrode.

Preferably, the laminar mechanical structures are made of glass and bear each a patterned electrode.

According to one preferred embodiment of the invention, the patterned electrode is made of a plurality of contiguous polygonal cells, delimiting non-conductive zones of the same shape, which size varies locally on said electrode surface. In this preferred embodiment, all conductive segments or areas are interconnected and thus delimit isolated individual non-conductive areas.

The patterned electrode of the invention can advantageously be achieved, either on one face of the piezoelectric or piezostritive material, the other face bearing possibly a continuous electrode, or on both faces of the piezoelectric or piezostritive material, with possibly different patterns on the two sides.

The patterned electrode is preferably made from etching a continuous electrode sheet or by serigraphy.

A resilient polymer film, such as polyvinylidene fluoride (PVDF), or a ceramic are preferably used as the piezoelectric active materials.

### Short description of the drawings

FIG.1 represents diagrammatically the shape of a state-of-the-art piezoelectric electrode for reconstructing the first mode of a beam clamped at one of its ends.

FIG.2 represents diagrammatically a state-of-the-art QWSIS sensor made of narrow unidirectional PVDF strips with electrodes of parabolic shape.

FIG.3 represents diagrammatically an arrangement of two orthogonal polynomial-shaped PVDF strips on a plate for the measurement of volume velocity.

FIG.4 represents diagrammatically a state-of-the-art selective modal transducer made of a sensor array.

FIG.5 shows typical weighting coefficients corresponding to the array arrangement of FIG.4 for reconstructing the volume velocity of a rectangular plate.

FIG.6 represents diagrammatically the shape of a typical modal filter for a cantilever beam, according to the invention.

FIG.7 represents diagrammatically a possible configuration for a filter acting on a plate to reconstruct the volume velocity, according to the invention.

FIG.8 represents diagrammatically the relationship between the effective piezoelectric properties and the porosity of an electrode according to the invention, as obtained by finite elements calculations.

## Detailed description of prior art

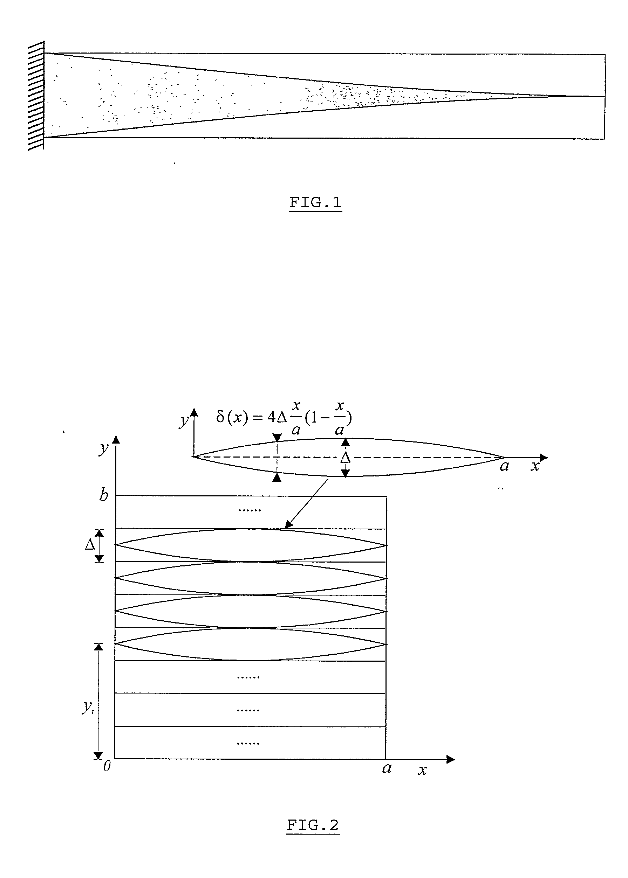

In a classical modal filter, a strip of piezoelectric material, for example PVDF, connected to a beam, is arranged and shaped by means of an electrode, such that the related sensor is sensitive only to one single mode of vibration. An example is shown in Fig.1 which displays the shape of the electrode for reconstructing the first mode of a beam clamped at one end. The same shape can be used as well for a modal actuator and a modal sensor.

In a Quadratically Weighted Strain Integrating sensor (QWSIS), an array of narrow unidirectional PVDF strips with electrodes of parabolic shape permits to measure the volume velocity of each individual strip, considered as a beam (FIG.2).

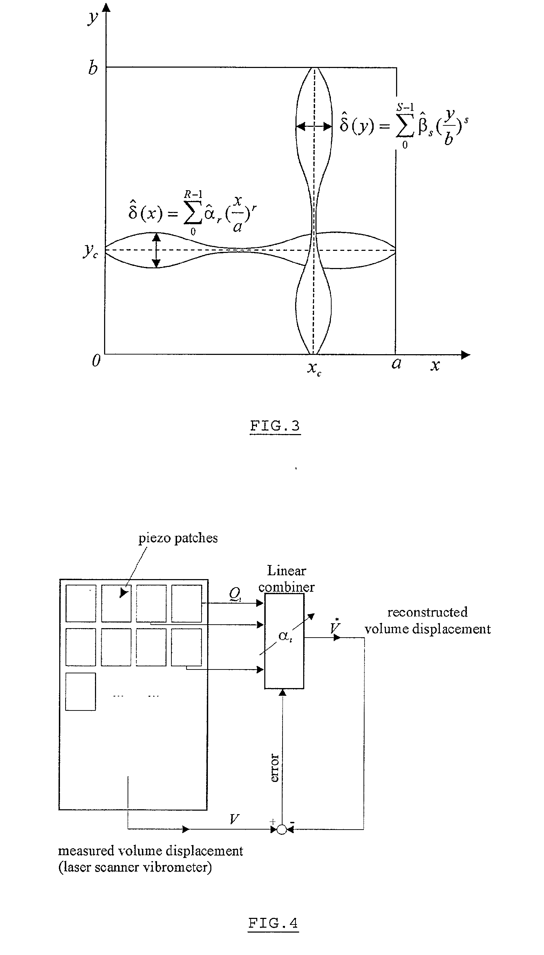

Another method for measuring the volume velocity consists of placing two PVDF strips orthogonal to each other across a plate. The polynomial shape of the electrode is selected in such a way that the output is equal to the volume velocity (FIG.3).

Alternatively, selective modal transducers can be constructed using array sensors (FIG.4).

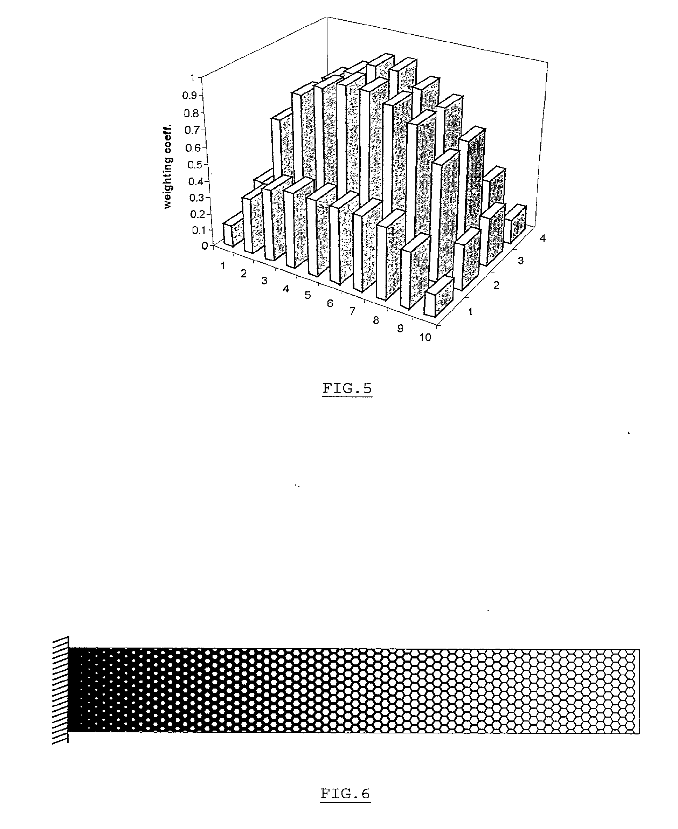

Figure 5 shows typical weighting coefficients for reconstructing the volume velocity of the rectangular plate of FIG.4, presenting 10, 4 respectively, piezoelectric array sensors in length, in width respectively.

## Description of a preferred embodiment of the invention

The main innovative concept at the origin of the present invention is to tentatively modulate the effective or apparent piezoelectric expansion coefficients of a piezoelectric film by designing a special pattern of the electrodes. Accordingly, small discrete non conductive areas of variable sizes are created at regular intervals in a continuous electrode, resulting in a virtually "porous" electrode.

The so-called porosity of an electrode will be defined hereinafter as the fraction of non conductive area relative to the total electrode area. The porosity can also be defined as local or as global.

Consequently, the effective behaviour of the active material is a direct function of the local porosity of the electrode. Various one or two-dimensional modal filters or volume velocity filters can thus be achieved by appropriate selection of the porosity of the electrode.

FIG.6 shows the shape of a typical modal filter for a cantilever beam, according to the present invention. On this figure, the electrode material is represented by the black areas, while the holes or material voids or "pores" are in white. This filter should be compared to the filter of Fig.1.

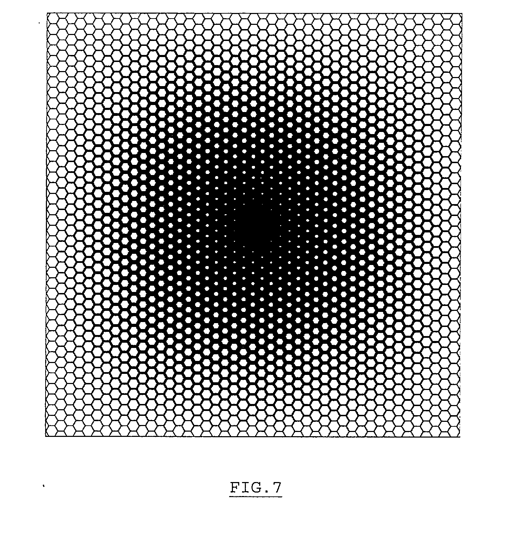

Alternatively, FIG.7 shows a possible configuration for a filter acting on a plate to reconstruct the volume velocity.

The output equation of a laminar piezoelectric sensor reads

$$V_{out} = -\frac{1}{C_r} \int_s (e_{31}\varepsilon_{11} + e_{32}\varepsilon_{22})dS,$$

where $V_{out}$ is the output voltage of the charge amplifier and $C_r$ its capacitance, $\varepsilon_{11}$ and $\varepsilon_{22}$ are the strain components of the mid-plane of the piezo-film, expressed in its orthotropy axes, and $e_{31}$ and $e_{32}$ are the piezoelectric coefficients of the material. The surface integral extents to the whole surface of the electrode.

The state-of-the-art technology in the polarization of piezoelectric materials does not allow to modulate the piezoelectric coefficients arbitrarily. However, the present invention allows to modulate the effective piezoelectric coefficients by using a special pattern of the electrodes which introduces a "porous" behaviour of the piezoelectric film. Discrete non conductive areas of small size are created at a regular mesh in the conductive electrode on the thin film. The part of the piezoelectric material located directly under the electrode responds as a normal piezoelectric material while the part located under a non-conductive area simply does not react as a piezoelectric material. The macroscopic behavior of a patch of piezoelectric film of finite size (homogenized) is that of a piezoelectric film with uniform electrode and reduced piezoelectric coefficients within the limits

$$0 \le e_{31} \le e_{31}^{max}, \, 0 \le e_{32} \le e_{32}^{max}.$$

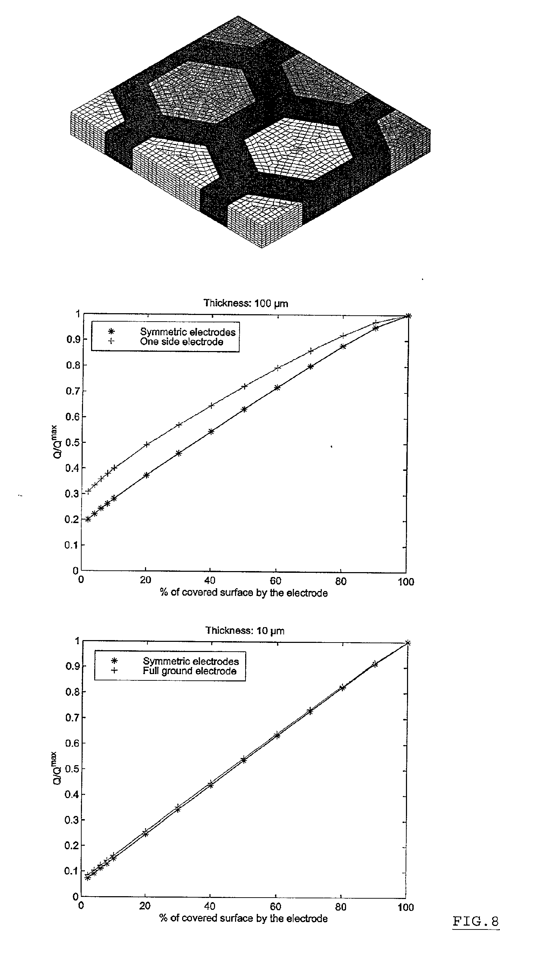

The relationship between the effective piezoelectric properties and the porosity of the electrode is monotonic although nonlinear, because of side effects on the electrodes. This is illustrated in FIG.8, which shows the results of finite element calculations for different piezoelectric material thicknesses (100 and 10 μm respectively). FIG.8 displays the fraction of electric charge $Q/Q^{max}$ generated by a sensor as a function of the porosity, for one-sided and two-sided electrodes, in each case. The "homogenization length", i.e. the length over which the effective expansion properties of the piezostrip can be seen as those of a strip with continuous (unporous) electrodes and reduced piezoelectric coefficients, depends on the size of the pattern in the electrode(s).

It is to be noted that the apparent porosity can be different from the geometric porosity, i.e. the percentage of surface covered by the electrode (FIG.8). This is the case for example when a portion of conductive material remains in a central void, but without any contact with the electrode electric lead (not represented). However in this case, the unconnected conductive material does by no way contribute to the in-plane apparent piezoelectric coefficients.

The present invention presents the following advantages over prior art :

- the solution is very simple and thus cheap to be industrially implemented ;
- the electrode can be obtained in one single piece ;
- the solution does not require any complicated electronic circuitry and is the only realistic or feasible way for 2D or 3D sensors;
- any given electrode pattern car be designed and realized as such or matter can be removed from a continuous piezoelectric strip (by etching, for example) ;
- the shape of the pores does not seem to be important, contrary to their size, in particular with respect to the homogenization length ;
- the result is independent of the nature of the piezoelectric material and of the electrode type ;
- the relationship between the generated electric charge and the porosity permits to calibrate the electrode.

**Claims**

1. Method for manufacturing a laminar piezoelectric, piezostrictive respectively, transducer, either a sensor or an actuator, with in-plane variable apparent piezoelectric, piezostrictive respectively, coefficients ($e_{31}$, $e_{32}$), comprising a piezoelectric, piezostrictive respectively, sheet covered on at least one of its faces by an electrode made of a conductive layer, **characterised in that** said in-plane coefficients ($e_{31}$, $e_{32}$) variation is obtained through the patterning of the electrode, by providing said conductive layer with a plurality of internal non-conductive zones.

2. Method according to Claim 1, **characterised in that** said patterned electrode is achieved, either on one face of the piezoelectric or piezostrictive material, the other face bearing possibly a continuous electrode, or on both faces of the material, with possibly different patterns on the two sides.

3. Method according to Claim 1 or 2, **characterised in that** said patterned electrode is preferably made from etching a continuous electrode sheet or by serigraphy.

4. Patterned electrode for a laminar piezoelectric or piezostrictive transducer, consisting in a sheet of electrically conductive material, obtained by the method according to any one of the preceding Claims.

5. Patterned electrode according to Claim 4, **characterised in that** said patterned electrode is made of a plurality of contiguous polygonal cells, delimiting non-conductive zones of the same shape, which size varies locally on said electrode surface.

6. Patterned electrode according to Claim 4 or 5, **characterised in that** said piezoelectric material is a resilient polymer film, preferably polyvinylidene fluoride (PVDF), or a ceramic.

7. Piezoelectric transducer comprising a laminar piezoelectric material intercalated between two laminar mechanical structures, on which is laid at least one patterned electrode according to anyone of Claims 4 to 6.

8. Piezostrictive transducer comprising a laminar piezostrictive material intercalated between two laminar mechanical structures, on which is laid at least one patterned electrode according to anyone of Claims 4 to 6.

9. Transducer according to Claim 7 or 8, **characterised in that** said laminar mechanical structures are made of glass and bear each a patterned electrode.

FIG.1

$$\delta(x) = 4\Delta \frac{x}{a}(1 - \frac{x}{a})$$

FIG.2

$$\hat{\delta}(y) = \sum_0^{S-1} \hat{\beta}_s (\frac{y}{b})^s$$

$$\hat{\delta}(x) = \sum_0^{R-1} \hat{\alpha}_r (\frac{x}{a})^r$$

FIG.3

piezo patches

Linear combiner

$Q_i$

$\alpha_i$

$\dot{V}$

reconstructed volume displacement

error

$V$

measured volume displacement
(laser scanner vibrometer)

FIG.4

FIG.5

FIG.6

FIG.7

Thickness: 100 µm

* Symmetric electrodes
+ One side electrode

Thickness: 10 µm

* Symmetric electrodes
+ Full ground electrode

FIG.8

**European Patent Office**

EUROPEAN SEARCH REPORT

Application Number

EP 01 87 0068

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | KIM S J ET AL: "System design of distributed modal transducers by adjusting spatial gain distribution" SMART STRUCTURES AND MATERIALS 1999: SMART STRUCTURES AND INTEGRATED SYSTEMS, NEWPORT BEACH, CA, USA, 1 - 4 MARCH 1999, vol. 3668, 1999, pages 968-979, XP001023817 Proceedings of the SPIE - The International Society for Optical Engineering ISSN: 0277-786X * page 968 - page 973; figures 2,3 * | 1,2,4,6,7 | H01L41/047 |
| A | WO 89 02658 A (CORNELL RESEARCH FOUNDATION INC) 23 March 1989 (1989-03-23) * page 45, line 17 - page 69, line 3; figures 8,9,15 * * page 20, line 5 - line 27 * | 1,3,4,6,7 | |
| A | US 4 786 837 A (KALNIN ILMAR L ET AL) 22 November 1988 (1988-11-22) * column 1, line 7 - column 8, line 63; figures 1,6 * | 1,2,4-7 | TECHNICAL FIELDS SEARCHED (Int.Cl.7) H01L B06B H04R |
| A | GB 2 157 075 A (HITACHI LTD) 16 October 1985 (1985-10-16) * page 3, line 34 - page 4, line 55; figures 9-12 * | 1-4 | |

The present search report has been drawn up for all claims

| Place of search | Date of completion of the search | Examiner |
|---|---|---|
| THE HAGUE | 3 September 2001 | Köpf, C |

**EP 1 246 267 A1**

## ANNEX TO THE EUROPEAN SEARCH REPORT
## ON EUROPEAN PATENT APPLICATION NO.

EP 01 87 0068

This annex lists the patent family members relating to the patent documents cited in the above-mentioned European search report.
The members are as contained in the European Patent Office EDP file on
The European Patent Office is in no way liable for these particulars which are merely given for the purpose of information.

03-09-2001

| Patent document cited in search report | | Publication date | Patent family member(s) | | Publication date |
|---|---|---|---|---|---|
| WO 8902658 | A | 23-03-1989 | US | 4868447 A | 19-09-1989 |
| | | | EP | 0381685 A | 16-08-1990 |
| | | | JP | 2501252 T | 26-04-1990 |
| US 4786837 | A | 22-11-1988 | NONE | | |
| GB 2157075 | A | 16-10-1985 | JP | 1827600 C | 28-02-1994 |
| | | | JP | 60199299 A | 08-10-1985 |
| | | | JP | 61019218 A | 28-01-1986 |
| | | | JP | 1829505 C | 15-03-1994 |
| | | | JP | 5042880 B | 29-06-1993 |
| | | | JP | 61020499 A | 29-01-1986 |
| | | | DE | 3510247 A | 03-10-1985 |
| | | | US | 4692653 A | 08-09-1987 |

EPO FORM P0459

For more details about this annex : see Official Journal of the European Patent Office, No. 12/82